(19) Europäisches Patentamt
European Patent Office
Office européen des brevets

(11) Publication number: **0 201 836**
**B1**

(12) # EUROPEAN PATENT SPECIFICATION

(45) Date of publication of patent specification: **13.09.89**

(51) Int. Cl.$^4$: **G 03 F 7/10**

(21) Application number: **86106132.3**

(22) Date of filing: **05.05.86**

(54) **Negative-working, non-swelling resist.**

(30) Priority: **16.05.85 US 734646**

(43) Date of publication of application:
**20.11.86 Bulletin 86/47**

(45) Publication of the grant of the patent:
**13.09.89 Bulletin 89/37**

(84) Designated Contracting States:
**DE FR GB**

(56) References cited:
**DD-A- 115 775**
**US-A-1 587 270**
**US-A-4 055 430**
**US-A-4 373 017**

**PATENT ABSTRACTS OF JAPAN, vol. 7, no. 228 (P-228)1373r, 8th October 1983; & JP-A-58 116 531 (FUJITSU K.K.) 11-07-1983**

(73) Proprietor: **EASTMAN KODAK COMPANY**
**343 State Street**
**Rochester New York 14650 (US)**

(72) Inventor: **Lindstrom, Michael Jeffrey**
**425 Willow Circle**
**Downing Town Pennsylvania 19335 (US)**

(74) Representative: **Parent, Yves et al**
**Kodak-Pathé Département Brevets et Licences**
**Centre de Recherches et de Technologie Zone Industrielle**
**F-71102 Chalon-sur-Saône Cédex (FR)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 201 836 B1

**Description**

This invention relates to photographically negative-working compositions suitable for exposure to activating radiation such as UV light to form a resist image.

One of the frontiers of photoresists involves the need for greater resolution, that is, for the resolution of smaller and smaller line widths. The reason is that semiconductor devices using such resists are packing more and more devices onto the same area. This is done primarily by reducing the dimensions of the devices — hence the need for smaller line widths.

The reduction in line widths has proceeded down to 1 µm or less, both in the line width and in the spacing. One result of this phenomenon has been the gradual abandoning by the industry of negative-working light-sensitive resists, that is, those having decreased solubility upon exposure to light, in favour of positive-working resists. Unlike the case with positive-working resists, the negative-working light-sensitive resists have a great tendency to swell upon development. Swelling is not a significant problem for line widths and spacings greater than 2 µm. But at 1 µm spacing or less, swelling of most negative-working resists has been enough to bridge the 1 µm spacing, resulting in stringers and other unacceptable defects noticeable upon drying.

What then has been needed prior to this invention is a negative-working light-sensitive resist that has no observable swelling, during development, when the image has 1 µm widths and spaces. The fact that positive-working resists will do this is not completely adequate — the availability of a negative-working light-sensitive resist would greatly expand the possible chemistries and more closely fit the processing format of some circuit designers.

Patent Abstracts of Japan, Vol. 7, No. 228 (P.228) (1373), October 8, 1983 discloses a negative-working resist comprising a binder and an alkali-soluble radiation-sensitive compound which insolubilizes the polymer upon irradiation of high energy radiation but does not disclose Applicants' sensitizer.

Compounds have been known prior to this invention for use in resists to generate color upon exposure, as a print-out indication of exposure dosage and uniformity. Some of these, for instance nitrile-substituted aminotriphenyl methane dyes, have been found to lose a —CN moiety upon exposure, as explained in "Dosimetry for Lithographic Applications", *J. Vac. Sci. Technol.,* Vol. 19, No. 4, Nov/Dec 1981, p. 1343—1347. Other print-out indica6ors have been found to lose a —$SO_2$— moiety as described in U.S. Patent 4,373,017 issued February 8, 1983 to Masukawa et al.

Still other examples of compounds becoming colored upon irradiation are known in the art, e.g., see U.S. Patent 4,055,430 and East German Patent 115,775. However, such compounds have not been identified, prior to this invention, as providing differential solubility. Thus, they have not been recognized as the basis for providing sensitivity to the resist, and most importantly, have not been appreciated as the basis for a negative-working resist free from swelling. Therefore, when used in resists to produce 1 µm line widths or spacing, the prejudice in the trade against negative-working resists has limited such compounds to use in positive-working resists.

I have discovered a negative-working resist that avoids the problem of swelling noted above, by a mechanism that is not entirely clear.

Thus it is an advantageous feature of the invention that a negative-working resist is provided that produces no observable swelling when developed to form line widths and spacings of 1 µm or less.

It is another advantageous feature of the invention that such a resist is sensitive to deep UV exposures.

Yet another advantageous feature of the invention is that the same radiation-sensitive compound providing differential solubility also can provide print-out color for the resist.

These features result, more specifically, from a light-sensitive negative-working non-swelling resist comprising a binder and a sensitizer which functions to impart differential solubility to said resist as a result of imagewise-exposure to activating radiation, thereby rendering said resist developable in an aqueous base, wherein said sensitizer is the sole radiation-sensitive compound of said resist, characterized in that the sensitizer has the structural formula:

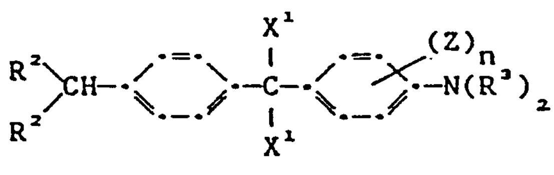

and upon exposure to said activating radiation, loses a moiety $HX^1$ and is converted to a colored compound that is less soluble in an aqueous base than is said sensitizer prior to said exposure, wherein $X^1$ and $R^2$ are selected from the group consisting of —CN, halide and —$SO_2R^1$ and $R^1$ is alkyl comprising from 1 to 5 carbon atoms or aryl comprising from 6 to 10 carbon ring atoms, $R^3$ is alkyl of from 1 to 5 carbon atoms or together the two $R^3$ moieties form with said N atom, one or two fused heterocyclic rings of 5 to 6 ring atoms each; n is 1 or 2 and Z is any substituent, or hydrogen which on exposure to said radiation produces no increase in aqueous-base solubility.

In accord with another aspect of the invention, there is also provided a method of producing a negative-working image in a resist composition. The method comprises the steps of a) imagewise-exposing

to activating radiation the aforesaid composition, and b) developing the exposed composition with an aqueous base so that only the exposed areas remain.

Certain compounds have been found to unexpectedly produce non-swelling negative-working resists when exposed to activating radiation. Although these compounds will be discussed primarily in connection with their preferred exposure sources, namely deep UV light sources defined as those having wavelengths including the range of 200—300 nm, they are also useful with other activating radiation.

The ability of these compounds to provide differential solubility to a selected solvent is well understood — it arises from the loss of an HX moiety upon exposure, causing the compound to transform into a form which is more insoluble in developer, wherein X is selected from the group consisting of —CN; halide such as chloride, fluoride, and the like; and $—SO_2R^1$; and $R^1$ is alkyl of from 1 to 5 carbon atoms, such as methyl, ethyl, propyl, isopropyl and the like; or aryl of from 6 to 10 carbon ring atoms, such as phenyl and naphthyl. What is not well understood is why this reaction and the compounds that provide it should be free of the swelling that plagues other negative-working resists.

In the process of forming the less soluble species, the resist of this invention reacts more at the surface, so that upon development the resist is undercut somewhat. This lends itself to using the resist in conventional lift-off techniques, since undercut resists are not likely to remain connected to adjacent components.

Particularly useful compounds for this resist comprise those having the structural formula

1

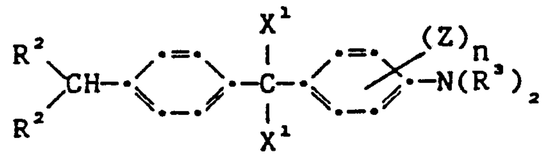

which is colorless, wherein $R^2$ and $X^1$ are individually selected from the group noted above for X. That is, $X^1$ is a species of the class of X moieties noted. When exposed, these compounds lose $HX^1$ to form

2

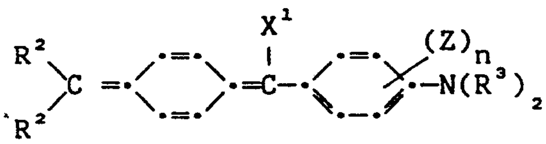

a colored species. In compounds *1* and *2* above, each $R^3$ is independently H, alkyl of from 1 to 5 carbon atoms, such as methyl, ethyl, propyl, isopropyl and the like, or benzyl; or together the two $R^3$ moieties form with the N atom, a heterocyclic ring of 5 or 6 ring atoms, such as morpholino or a pair of fused heterocyclic rings of 5 or 6 ring atoms each such as julolidyl; n is 1 or 2; and Z is any substituent, or hydrogen, which upon exposure does not interfere with the negative-working properties of the resist. That is, Z is selected so as to produce no significant increase in solubility in aqueous bases such as are useful as developers. For example, Z can be H, alkyl of from 1 to 5 carbon atoms, such as methyl, ethyl, propyl, isopropyl and the like; benzo; or alkoxy of from 1 to 5 carbon atoms, such as methoxy, ethoxy, propoxy, and the like.

Particularly preferred examples from this class of compounds include:

(A)

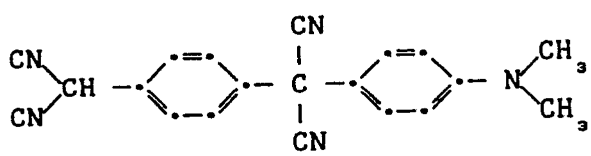

4-(α,α-dicyano-4-dicyanomethylbenzyl)-N,N-dimethylaniline;

(B)

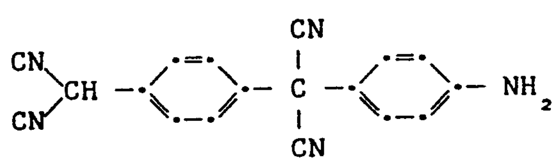

4-(α,α-dicyano-4-dicyanomethylbenzyl)aniline;

(C)

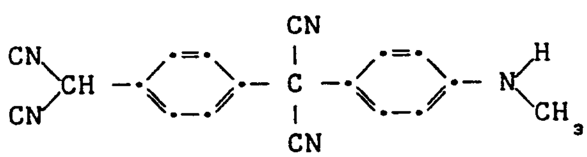

4-(α,α-dicyano-4-dicyanomethylbenzyl)-N-methylaniline;

(D)

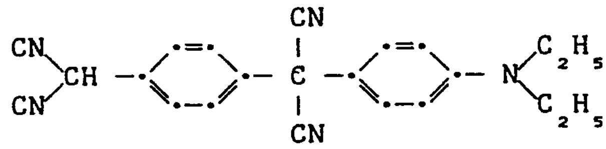

4-(α,α-dicyano-4-dicyanomethylbenzyl)-N,N-diethylaniline;

(E)

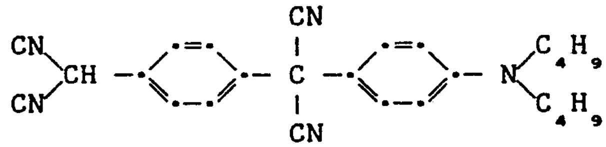

4-(α,α-dicyano-4-dicyanomethylbenzyl)-N,N-dibutylaniline;

(F)

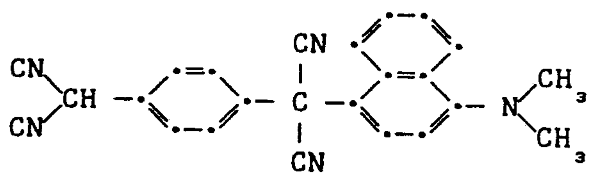

4-(α,α-dicyano-4-dicyanomethylbenzyl)-N,N-dimethyl-1-naphthylamine;

(G)

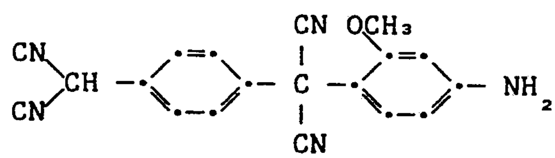

4-(α,α-dicyano-4-dicyanomethylbenzyl)-3-methoxyaniline;

(H)

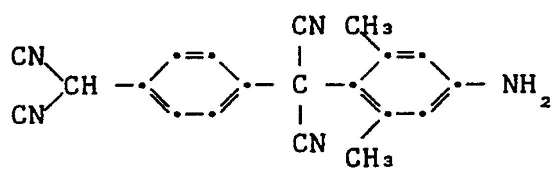

4-(α,α-dicyano-4-dicyanomethylbenzyl)-3,5-dimethylaniline;

(I)

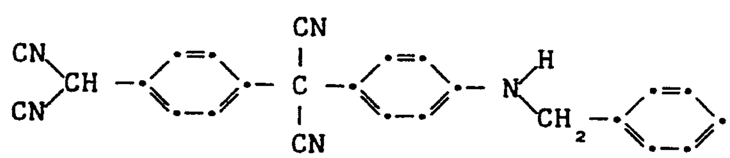

4-(α,α-dicyano-4-dicyanomethylbenzyl)-N-benzylaniline;

(J)

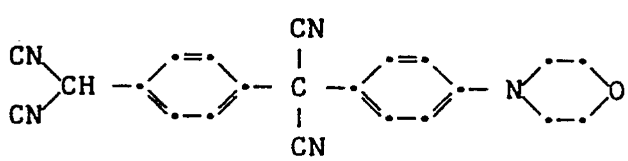

4-(α,α-dicyano-4-dicyanomethylbenzyl)-1-morpholinobenzene; and

(K)

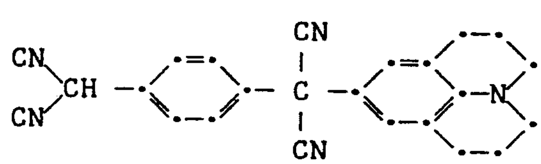

9-(α,α-dicyano-4-dicyanomethylbenzyl)julolidene.

Another useful class of colorless compounds includes those having the structural formula

3 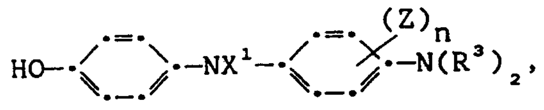

wherein $X^1$, $R^3$, Z and n have the meaning noted above. Upon exposure, such compounds also lose $HX^1$ and form

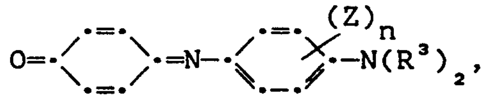

also a colored species. Although this class tends to show more thickness loss upon development, an undesirable feature, it is considered that other, more selective aqueous base developers can be used with this class to keep such thickness losses within acceptable ranges. Examples include those developers that include tetraalkylammonium or phosphonium cations, such as are described in U.S. Patent No. 4,423,138, issued on December 17, 1983.

The compounds of this invention, which lose the moiety HX to provide differential solubility, are the sole radiation-sensitive compounds of the composition, to insure the lack of swelling upon development. The compounds of this invention preferably are present in an amount greater than 10% by weight, most preferably greater than 15% by weight, of the dried coating composition.

Synthesis of the compounds of class *1* or *3* proceeds generally as follows:

For class *1*,

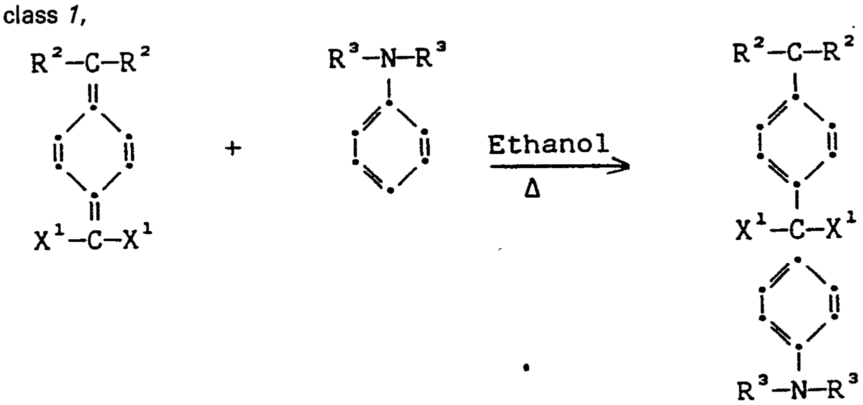


More particularly, Compound A has been synthesized as follows:

1 g of tetracyanoquinodimethane and 0.6 g N,N-dimethylaniline were refluxed in 30 mL of ethanol for 1 hour. The dark green solution was filtered hot and allowed to cool. The resulting crystals were collected, washed with additional ethanol and air dried to yield 1.3 g light yellow plates M.P. 145—7°C.

| | | | |
|---|---|---|---|
| Calculated: | C, 73.8; | H, 4.6; | N, 21.5. |
| Found: | C, 73.3; | H, 4.8; | N, 21.3. |

Table I lists other representative compounds of the invention that have been prepared similarly.

Table I

| Compound | % Yield | M.P. °C | Analysis Calc'd./Found C | H | N |
|---|---|---|---|---|---|
| B | 55 | 140–1 | 72.7/71.1 | 3.7/3.9 | 23.6/23.1 |
| C | 50 | 110–112 | 73.3/73.1 | 4.2/4.4 | 22.5/22.8 |
| D | 35 | 95–6 | 74.8/74.1 | 5.4/5.3 | 19.8/19.9 |
| E | 40 | 97–8 | 76.3/75.9 | 6.6/6.6 | 17.1/17.3 |
| F | 50 | 82–95 | 76.8/77.0 | 4.6/5.2 | 18.7/17.3 |
| G | 37 | 108–9 | 69.7/69.1 | 4.0/4.3 | 21.4/20.9 |
| H | 63 | 192–4 | 73.8/73.8 | 4.6/5.1 | 21.5/21.7 |
| I | 32 | 137–8 | 77.5/77.4 | 4.4/4.3 | 18.1/18.1 |
| J | 67 | 175–6 | 71.9/71.4 | 4.7/4.6 | 19.1/18.9 |
| K | 43 | 147–8 | 76.4/76.2 | 5.1/5.1 | 18.6/18.5 |

A similar synthesis is used to prepare compounds of class *3* above, except that dimethylformamide is used as the solvent in place of ethanol.

Any binder is useful in this composition, such as conventional non-radiation sensitive binders. Particularly useful examples include the well-known novolak resins, that is, those having the structural formula:

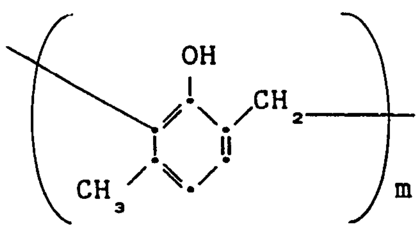

Other aromatic, base soluble binders having good plasma etch resistance and thermal resistance to at least 150°C are also particularly useful.

Other addenda can be optionally added to the composition, for example, stabilizers, surfactants, and the like.

Examples

The following examples further illustrate the scope of the invention.

Example 1 — Use of class 1 compound

The following composition was spin-coated at 4000 rpm on chrome-clad glass plates:

| Component | Amount |
|---|---|
| Cresol-formaldehyde resin binder | 1.0 g |
| Compound A | 0.2 g |
| FC170C non-ionic fluorocarbon Surfactant obtained from 3M | 5.9 mg |
| 2-Ethoxyethyl acetate | 3.6 g |

The dried coated plates were prebaked at 90°C for 30 minutes, then contact exposed through a quartz mask with an Optical Associates Instrument exposure device using a deep UV source and 220 nm mirrors for 30 s. Upon exposure to an image of lines having widths and spacing of 1 µm or less, a bright blue image printed out. The exposed plates were developed in 1% aqueous sodium hydroxide for 15 s at room temperature or in 1:3 tetramethylammonium hydroxide/water for 30 s at room temperature. Crisp negative images were formed as unexposed areas were washed away rapidly. Image resolution was ≈0.5 µm. There was less than 1% thickness loss in the exposed areas, and no swelling had occurred on development.

Example 2 — Use with a Different Binder

A composition was prepared similar to that of Example 1 except that the novolak binder was replaced by 1.0 g of poly(4-hydroxystyrene). The composition was spin-coated at 4000 rpm on chrome-clad plates. As in Example 1 a dried plate sample was prebaked, exposed, and processed in aqueous base. As in Example 1 a blue printout image was observed upon exposure and image resolution was ≈0.5 µm with less than 1% thickness loss observable in the exposed areas after processing. No swelling had occurred on development.

Example 3 — Use of Class 3 Compound

A composition was prepared similar to that of Example 2, except that the radiation-sensitive compound was 0.6 g of

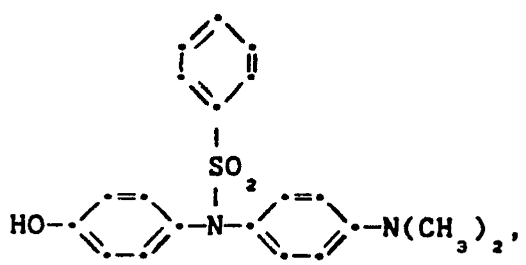

prepared with 6.4 g of cyclohexanone as the solvent. Exposure was for 40 s, and development was for 10 s in a solution containing 3 parts water and 1 part silicate-phosphate developer containing 1.45 parts by weight $Na_3PO_4 \cdot 12H_2O$ and 1 part by weight $Na_2SiO_3 \cdot 9H_2O$.

## Claims

1. A light-sensitive negative-working non-swelling resist comprising a binder and a sensitizer which functions to impart differential solubility to said resist as a result of imagewise-exposure to activating radiation, thereby rendering said resist developable in an aqueous base, wherein said sensitizer is the sole radiation-sensitive compound of said resist, characterized in that the sensitizer has the structural formula:

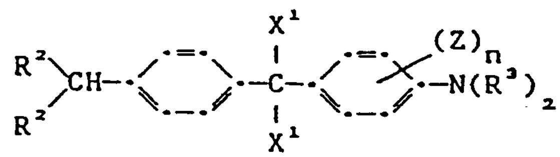

and upon exposure to said activating radiation, loses a moiety $HX^1$ and is converted to a colored compound that is less soluble in an aqueous base than is said sensitizer prior to said exposure, wherein $X^1$ and $R^2$ are selected from the group consisting of —CN, halide and —$SO_2R^1$ and $R^1$ is alkyl comprising from 1 to 5 carbon atoms or aryl comprising from 6 to 10 carbon ring atoms, $R^3$ is alkyl of from 1 to 5 carbon atoms or together the two $R^3$ moieties form with said N atom, one or two fused heterocyclic rings of 5 to 6 ring atoms each; n is 1 or 2 and Z is any substituent, or hydrogen which on exposure to said radiation produces no increase in aqueous-base solubility.

2. A resist as described in claim 1 wherein said sensitizer has the structural formula:

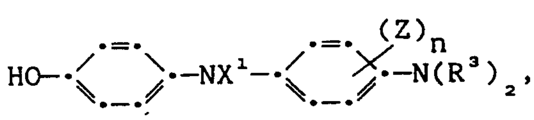

wherein $X^1$, $R^3$, Z and n have the same signification as in claim 1.

3. A method of producing a negative-working image in a light-sensitive resist, comprising the steps of

a) imagewise-exposing to activating radiation the resist defined in claims 1 or 2 and,

b) developing said exposed resist with an aqueous base so that only the exposed areas remain.

**Patentansprüche**

1. Lichtempfindliches, negativ arbeitendes, nicht-quellendes Resist mit einem Bindemittel und einem Sensibilisator, der als Folge einer bildweisen Exponierung gegenüber aktivierender Strahlung dem Resist eine unterschiedliche Löslichkeit verleiht, wodurch das Resist in einer wäßrigen Base entwickelbar gemacht wird, wobei der Sensibilisator die einzige strahlungsempfindliche Verbindung des Resists ist, dadurch gekennzeichnet, daß der Sensibilisator der folgenden Strukturformel entspricht:

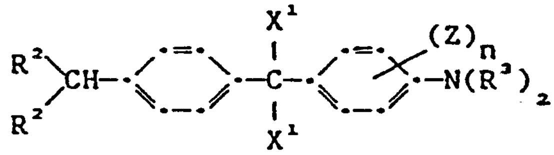

und bei der Exponierung gegenüber der aktivierenden Strahlung eine Gruppe $HX^1$ verliert und in eine farbige Verbindung überführt wird, die in einer wäßrigen Base weniger löslich ist als der Sensibilisator vor der Exponierung, wobei $X^1$ und $R^2$ ausgewählt sind aus der Gruppe bestehend aus —CN, Halogenid und —$SO_2R^1$ und $R^1$ für einen Alkylrest mit 1 bis 5 Kohlenstoffatomen oder einen Arylrest mit 6 bis 10 Ringkohlenstoffatomen steht, $R^3$ ein Alkylrest mit 1 bis 5 Kohlenstoffatomen ist oder die zwei $R^3$ Reste gemeinsam mit dem N-Atom einen oder zwei kondensierte heterocyclische Ringe mit jeweils 5 bis 6 Ringatomen bilden; n gleich 1 oder 2 ist und Z für irgendeinen Substituenten oder Wasserstoff steht, der bei der Exponierung gegenüber der Strahlung zu keiner Erhöhung der Löslichkeit in der wäßrigen Base führt.

2. Resist nach Anspruch 1, in dem der Sensibilisator die folgende Strukturformel hat:

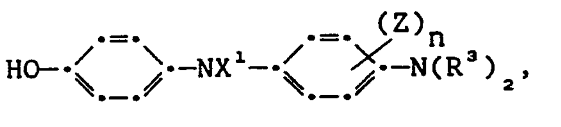

in der $X^1$, $R^3$, Z und n die gleiche Bedeutung wie in Anspruch 1 haben.

3. Verfahren zur Herstellung eines negativ arbeitenden Bildes in einem lichtempfindlichen Resist, mit den Stufen

a) der bildweisen Exponierung des Resists nach Ansprüchen 1 oder 2 gegenüber aktivierender Strahlung und

b) Entwicklung des exponierten Resists mit einer wäßrigen Base derart, daß nur die exponierten Bezirke hinterbleiben.

**Revendications**

1. Photoréserve négative ne gonflant pas, comprenant un liant et un sensibilisateur qui procure une solubilité différentielle à ladite réserve en réponse à une exposition à un rayonnement activant, rendant ainsi ladite réserve développable dans une base aqueuse, dans laquelle ledit sensibilisateur est le seul composé de ladite réserve sensible au rayonnement, réserve caractérisée en ce que ledit sensibilisateur a la formule suivante:

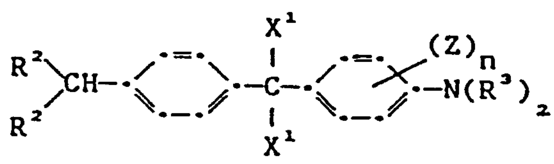

et à l'exposition au rayonnement activant, perd un groupe $HX^1$ et est transformé en un composé coloré qui est moins soluble dans une base aqueuse que ne l'est ledit sensibilisateur avant l'exposition, où $X^1$ et $R^2$ sont choisis dans le groupe comprenant —CN, les halogénures et —$SO_2R^1$, et $R^1$ est un groupe alkyle comprenant de 1 à 5 atomes de carbone ou aryle comprenant de 6 à 10 atomes de carbone sur le cycle, $R^3$ est un groupe alkyle de 1 à 5 atomes de carbone, ou bien les deux groupes $R^3$ forment ensemble avec ledit atome d'azote un ou deux hétérocycles condensés ayant chacun 5 à 6 atomes sur le cycle; n est 1 ou 2 et Z est n'importe quel substituant, ou bien un atome d'hydrogène qui à l'exposition au rayonnement ne produit aucune augmentation de la solubilité dans les bases aqueuses.

2. Photoréserve selon la revendication 1 dans laquelle le sensibilisateur a la formule:

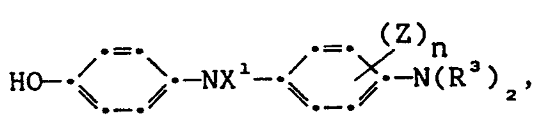

où $X^1$, $R^3$, Z et n sont tels que définis dans la revendication 1.

3. Méthode pour produire une image négative dans une photoréserve, comprenant les étapes suivantes:

a) on expose la réserve telle que définie dans les revendications 1 ou 2 au rayonnement activant et,

b) on développe ladite réserve avec une base aqueuse de telle sorte que seules les régions exposées restent intactes.